# EUROPEAN PATENT APPLICATION

(11) **EP 2 551 904 A1**
(43) Date of publication of application: **30.01.2013**
(21) Application number: 12177861.7
(22) Date of filing: 25.07.2012
(51) Int. Cl.: H01L 25/10

(54) **Semiconductor device, semiconductor module structure configured by vertically stacking semiconductor devices, and manufacturing method thereof**

(30) Priority: 28.07.2011 JP 2011165200
(71) Applicant: J-Devices Corporation, Usuki-shi, Oita (JP)
(72) Inventor: Yamagata, Osamu, Kanagawa 212-8583 (JP); Katsumata, Akio, Kanagawa 212-8583 (JP); Inoue, Hiroshi, Kanagawa 212-8583 (JP); Sawachi, Shigenori, Kanagawa 212-8583 (JP); Itakura, Satoru, Kanagawa 212-8583 (JP); Yamaji, Yasuhiro, Kanagawa 212-8583 (JP)
(74) Representative: Schwabe - Sandmair - Marx

(57) **Abstract**

A semiconductor device, comprising: an organic substrate 1; through vias 4 which penetrate the organic substrate 1 in its thickness direction; external electrodes 5b and internal electrodes 5a provided to the front and back faces of the organic substrate 1 and electrically connected to the through vias 4; a semiconductor element mounted on one main surface of the organic substrate 1 via a bonding layer 3, with an element circuit surface thereof facing upward; an insulating material layer 6 for sealing the semiconductor element and a periphery thereof; a metal thin film wiring layer 7 provided in the insulating material layer, with a part of this metal thin film wiring layer being exposed on an external surface; metal vias 10 provided in the insulating material layer and electrically connected to the metal thin film wiring layer; and external electrodes 9 formed on the metal thin film wiring layer 7, wherein the metal thin film wiring layer 7 is structured such that the electrodes disposed on the element circuit surface of the semiconductor element 2, the internal electrodes 5a, the metal vias 10, and the external electrodes 9 formed on the metal thin film wiring layer are electrically connected.

## Description

### BACKGROUND OF THE INVENTION

### 1. Field of the Invention

The present invention relates to a semiconductor device, a semiconductor module structure configured by stacking semiconductor devices, and the manufacturing method thereof.

More specifically, the present invention relates to a Panel scale Fan-out package structure in which the thin film wiring process and assembly process are performed with a large panel scale, and in particular the present invention can be applied to a semiconductor stacked module having a structure where a plurality of packages are stacked vertically.

### 2. Description of the Related Art

Pursuant to the recent demands for higher functionality and lighter, thinner and smaller electronic equipment, the high-density integration and even high-density mounting of electronic components have advanced, and the downsizing of semiconductor devices used in the foregoing electronic equipment is also advancing than ever before.

As a method of manufacturing a semiconductor device such as an LSI unit or an IC module, there is a method comprising foremost disposing and affixing, in a predetermined arrangement, a plurality of semiconductor elements, which were determined as being non-defective in electrical property testing, on a retention plate with the element circuit surfaces thereof facing down, thereafter collectively resin-sealing the plurality of semiconductor elements, for instance, by disposing thereon a resin sheet and molding it via heating and pressing, subsequently peeling the retention plate, cutting and processing the resin-sealed body into a predetermined shape (circle, for example), thereafter forming an insulating material layer on the element circuit surfaces of the semiconductor elements embedded in the resin-sealed body, forming openings in the insulating material layer so as to be aligned with electrode pads of the semiconductor elements, thereafter forming a wiring layer on the insulating material layer, forming conductive parts (via parts) in the openings for connecting to the electrode pads of the semiconductor elements, subsequently forming a solder resist layer, forming solder balls as external electrode terminals, and thereafter individually cutting the semiconductor elements to complete the semiconductor devices (for instance, refer to Japanese Patent Application Publication No. 2003-197662).

Nevertheless, with a conventional semiconductor device obtained as described above, upon collectively resin-sealing a plurality of semiconductor elements, since the resin hardens and shrinks, and the amount of shrinkage is not necessarily as designed, there are cases where the position after the resin hardening deviates from the designed position depending on the arrangement of the semiconductor elements, and, with a semiconductor element having such a positional deviation, a positional deviation is formed between the via parts formed in the openings of the insulating material layer and the electrode pads of the semiconductor element, and there is a problem in that the connection reliability will deteriorate.

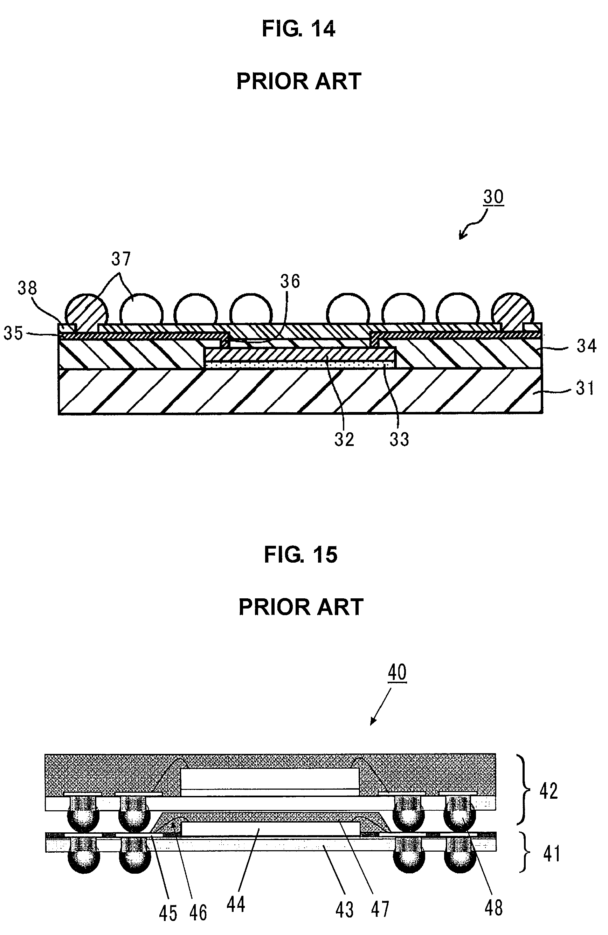

A semiconductor device that resolved the foregoing problem is described in Japanese Patent Application Publication No.2010-219489.
The basic structure of this semiconductor device is shown in Fig. 14.

A semiconductor device 30 comprises a flat plate 31 configured from a resin-hardened body or metal, a semiconductor element 32 is disposed on one main surface thereof with an element circuit surface facing up, and a face (back face) that is opposite to the element circuit surface is fixed to the flat plate 31 via an adhesive 33. In addition, one insulating material layer 34 is formed on the entire main surface of the flat plate 31 so as to cover the element circuit surface of the semiconductor element 32. A wiring layer 35 made of conductive metal such as copper is formed on the foregoing single insulating material layer 34, and a part there of is led out to a peripheral region of the semiconductor element 32. Moreover, via parts 36 are formed in the insulating material layer 34 formed on the element circuit surface of the semiconductor element 32 for electrically connecting the electrode pads (not shown) and the wiring layer 35 of the semiconductor element 32. The via parts 36 are collectively and integrally formed with the wiring layer 35. Moreover, a plurality of solder balls 37 as external electrodes are formed at a predetermined position on the wiring layer 35. In addition, a protective layer such as a solder resist layer 38 is formed on the insulating material layer 34 and on the wiring layer 35 excluding the part that is bonded with the solder balls 37.

The semiconductor device described in Japanese Patent Application Publication No. 2010-219489 has high connection reliability between the electrodes of the semiconductor element and wiring layer based on the foregoing configuration, and enables the production of a semiconductor device, which is compatible with the miniaturization of electrodes, inexpensively and with a high production yield.

Nevertheless, with the semiconductor device described in Japanese Patent Application Publication No. 2010-219489, it is difficult to provide vias which penetrate the front and back faces of the package and, therefore, there is a problem in that the device cannot meet the demand for application for a stacked module of a three-dimensional structure in which other semiconductor packages or circuit boards are stacked on a semiconductor package and which is disseminating rapidly recent years.

As recent trends, the downsizing of the semiconductor package size and the increase in the number of semiconductor elements to be mounted are being demanded. In order to meet these demands, the following have been proposed and developed; namely, a semiconductor device having a POP (Package on Package) structure in which other semiconductor packages or circuit boards are stacked on a semiconductor package (Japanese Patent Application Publication No. 2008-218505) and a semiconductor device having a TSV (Through Silicon Via) structure (Japanese Patent Application Publication No. 2010-278334).

A conventional POP structure semiconductor device is now explained based on Fig. 15. POP (Package on Package) is a package mode in which a plurality of different LSIs are assembled as individual packages, tested, and additionally stacking the packages thereafter.

The semiconductor device 40 is configured by another semiconductor package 42 being stacked on a semiconductor package 41. A semiconductor element 44 is mounted on the substrate 43 of the lower semiconductor package 41, and electrode pads (not shown) formed at the periphery of the semiconductor element 44 and electrode pads 45 on the substrate are electrically connected via wires 46. The entire surface of the semiconductor element 44 is sealed with a sealing member 47. In addition, the semiconductor package 41 and the semiconductor package 42 are mutually electrically connected based on reflow via external connecting terminals 48 (solder balls) formed on the lower face of the semiconductor package 42.

POP is advantageous in that the mounting area can be increased upon mounting devices as a result of stacking a plurality of packages as described above, and, since each package can be individually tested, the production yield loss can be reduced. Nevertheless, with POP, since the individual packages are individually assembled and the completed packages are stacked, it is difficult to reduce the assembly costs based on the reduction (shrinkage) of the semiconductor element size, and there is a problem in that the assembly cost of the stacked module is extremely expensive.

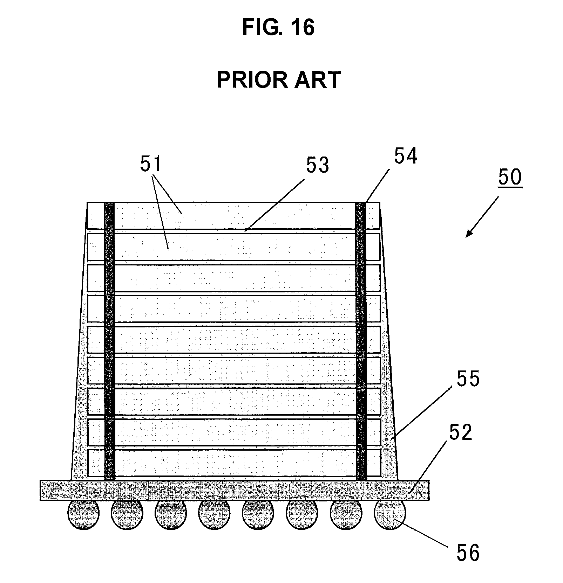

A conventional TSV structure semiconductor device is now explained with reference to Fig. 16. As shown in Fig. 16, a semiconductor device 50 has a structure in which a plurality of semiconductor elements 51 mutually having the same function and structure and which are respectively prepared using the same manufacture mask and one interposer substrate 52 are stacked via a resin layer 53. Each semiconductor element 51 is a semiconductor element using a silicon substrate, and is electrically connected to the upper and lower adjacent semiconductor elements via multiple through electrodes (TSV: Through Silicon Via) 54 that penetrate the silicon substrate and sealed with sealing resin 55. Meanwhile, the interposer substrate 52 is a circuit board made of resin, and a plurality of external connecting terminals (solder balls) 56 are formed on the back face thereof.

With a conventional TSV (Through Si Via) stacked module structure, since through-holes are provided to each of the individual semiconductor elements, there is a possibility that the semiconductor element will become damaged, and it is also necessary to add several complex and costly wafer processes of forming via electrodes in the through-holes. Thus, this resulted in a considerable cost increase of the overall vertically stacked module. Moreover, with the conventional structure, it is difficult to stack and mount chips of different sizes, and, due to the "provision of different rewiring layers for each layer" which is essential upon lamination on the same chip as in a memory device, the manufacture costs increase considerably in comparison to ordinary memory modules, and there is a problem in that the cost reduction based on mass production cannot be expected.

### SUMMARY OF THE INVENTION

The present invention was made in order to solve the foregoing problems, and an object of this invention is to provide a semiconductor device having a structure including electrodes which penetrate the front and back faces, which can adopt a vertically-stacked structure including a POP-type structure, and in which LSI chips of different sizes can be easily stacked vertically.

As a result of intense study to achieve the foregoing object, the present inventors completed the present invention by discovering that the foregoing object can be achieved with the following configuration; using an organic substrate as the support for mounting the semiconductor element, providing through vias which penetrate the organic substrate in a thickness direction, providing external electrodes and internal electrodes provided to the front and back faces face of the organic substrate and electrically connected to the through vias, and electrically connecting the electrodes disposed on the element circuit surface of the semiconductor element, the internal electrodes, the metal vias in the insulating material layer, and the external electrodes formed on the metal thin film wiring layer via the metal thin film wiring layer provided in the insulating material layer.

In other words, the present invention is as described below.
(1) A semiconductor device, comprising:
   an organic substrate;
   through vias which penetrate the organic substrate in its thickness direction;
   external electrodes and internal electrodes provided to the front and back faces of the organic substrate and electrically connected to the through vias;
   a semiconductor element mounted on one main surface of the organic substrate via a bonding layer, with an element circuit surface thereof facing upward;
   an insulating material layer for sealing the semiconductor element and a periphery thereof;
   a metal thin film wiring layer provided in the insulating material layer, with a part of this metal thin film wiring layer being exposed on an external surface;
   metal vias provided in the insulating material layer and electrically connected to the metal thin film wiring layer; and
   external electrodes formed on the metal thin film wiring layer,
   wherein the metal thin film wiring layer is structured such that the electrodes disposed on the element circuit surface of the semiconductor element, the internal electrodes, the metal vias, and the external electrodes formed on the metal thin film wiring layer are electrically connected.
(2) The semiconductor device according to (1) above, wherein the insulating material layer is formed of a plurality of insulating material layers made of respectively different insulating materials.
(3) The semiconductor device according to (1) or (2) above, wherein the metal thin film wiring layer and the metal vias connected thereto are provided in the form of a plurality of layers.
(4) The semiconductor device according to any one of (1) to (3) above, wherein through vias, which are not electrically connected to the metal thin film wiring layer in the insulating material layer, is disposed in a region of the organic substrate facing the semiconductor element.
(5) The semiconductor device according to any one of (1) to (4) above, wherein a plurality of semiconductor elements are provided on the organic substrate.
(6) A module structure in which a plurality of the semiconductor devices according to any one of (1) to (5) above are stacked in a direction which is vertical to a main plane of the semiconductor device by connecting the external electrodes formed on the metal thin film wiring layer of one of the semiconductor devices and external electrodes exposed on the organic substrate of the other semiconductor device.
(7) The module structure according to (6) above,
   wherein the semiconductor device is the semiconductor device according to (4) above.
(8) A method of manufacturing a semiconductor device, comprising the steps of:
   forming in an organic substrate through vias which penetrate the organic substrate in a thickness direction;
   forming external electrodes and internal electrodes provided to the front and back faces of the organic substrate and electrically connected to the through vias;
   positioning and disposing a plurality of semiconductor elements on one main surface of the organic substrate, with element circuit surfaces thereof facing upward, and then fixing faces, which are opposite to the element circuit surfaces of these semiconductor elements, onto the organic substrate;
   forming an insulating material layer on the semiconductor elements and a periphery thereof;
   forming openings in the insulating material layer;
   forming on the insulating material layer a metal thin film wiring layer, a part of which extends to a peripheral region of the semiconductor element, and forming metal vias as conductive parts, which are connected to electrodes disposed on the element circuit surfaces of the semiconductor elements, in the openings in the insulating material layer;
   forming external electrodes on the metal thin film wiring layer; and
   separating the semiconductor devices including one or more semiconductor chips by cutting the organic substrate and the insulating material layer at predetermined positions.
(9) A method of manufacturing a semiconductor stacked module, wherein a plurality of the semiconductor devices according to any of (1) to (5) above are stacked in a direction which is vertical to a principal plane of the semiconductor device in such a manner that the external electrodes formed on the metal thin film wiring layer of one of the semiconductor devices is connected to the external electrodes exposed on the organic substrate of another semiconductor device.

The semiconductor device of the present invention yields the following effects.

A vertically-stacked structure, in a POP-type structure, etc. is enabled. LSI chips without through electrodes can be easily stacked vertically. Considerable cost reduction based on the downsizing of the semiconductor element size is realized by a large-panel scale assembly. Manufacture costs can be considerably reduced since the provision of different wiring layers for each layer, which was essential upon lamination on the same chips as in a memory device, etc. is no longer required. Damage to the device when using a TSV process can be prevented. Handling of thin chips is facilitated. Thermal properties can be improved with the thermal vias.

### BRIEF DESCRIPTION OF THE DRAWINGS

Fig. 1 is a cross-sectional view showing Embodiment 1 of the semiconductor device according to the present invention.

Figs. 2A to 2E show the method of manufacturing the semiconductor device of Embodiment 1, and are the cross-sectional views showing a part of the process thereof.

Figs. 3F to 3I show the method of manufacturing the semiconductor device of Embodiment 1, and are the cross-sectional views showing a part of the process thereof.

Figs. 4J and 4K show the method of manufacturing the semiconductor device of Embodiment 1, and are the cross-sectional views showing a part of the process thereof.

Fig. 5 is a cross-sectional view showing Embodiment 2 of the semiconductor device according to the present invention.

Fig. 6 is a cross-sectional view showing Embodiment 3 of the semiconductor device according to the present invention.

Fig. 7 is a cross-sectional view showing Embodiment 4 of the semiconductor device according to the present invention.

Fig. 8 is a cross-sectional view showing Embodiment 5 of the semiconductor device according to the present invention.

Fig. 9 is a cross-sectional view showing Embodiment 6 of the semiconductor device according to the present invention.

Fig. 10 is a cross-sectional view showing Embodiment 7 of the semiconductor device according to the present invention.

Fig. 11 is a cross-sectional view showing Embodiment 8 of the semiconductor device according to the present invention.

Fig. 12 is a cross-sectional view showing Embodiment 9 of the semiconductor device according to the present invention.

Fig. 13 is a cross-sectional view showing Embodiment 10 of the semiconductor device according to the present invention.

Fig. 14 is a cross-sectional view showing the structure of a conventional semiconductor device.

Fig. 15 is a diagram showing the structure of a conventional POP structure semiconductor device.

Fig. 16 is a diagram showing the structure of a conventional TSV structure semiconductor device.

### DESCRIPTION OF THE PREFERRED EMBODIMENTS

The embodiments for carrying out the present invention are now explained. Note that, while the embodiments are explained below with reference to the drawings, the drawings thereof are provided for graphic explanation only, and the present invention is not limited to the drawings in any way.

### Embodiment 1

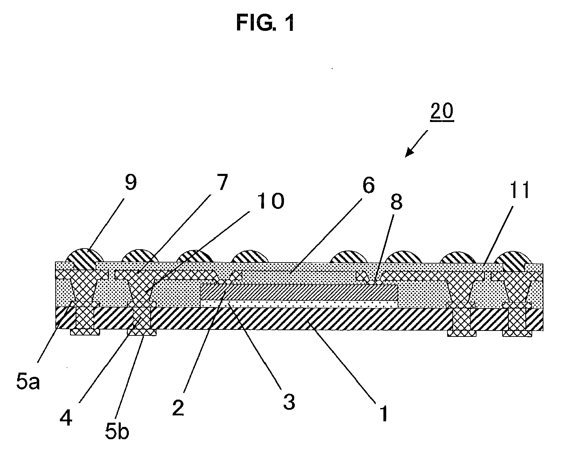

Fig. 1 is a vertical cross-sectional view showing Embodiment 1 which represents the basic configuration of the semiconductor device according to the present invention.

The semiconductor device 20 comprises an organic substrate 1 constituted by a resin-hardened body, a semiconductor element 2 is disposed on one main surface thereof with an element circuit surface having electrodes (not shown) facing up, and a face (back face) that is opposite to the element circuit surface is fixed to the organic substrate 1 via an adhesive 3. Through vias 4 are provided to the organic substrate 1 which penetrate the organic substrate in a thickness direction, and internal electrodes 5a and external electrodes 5b which are electrically connected to the through vias 4 are provided to the front and back faces of the organic substrate 1. Since through-holes for providing the through vias 4 are formed in the organic substrate 1, a material with high processing strength can be used as the organic substrate material. As this kind of organic substrate 1, for example, a compound material in which resin is impregnated in a glass cloth can be used. Moreover, both faces of the organic substrate is covered by a copper foil.

In addition, an insulating material layer 6 is formed on the entire main surface of the organic substrate 1 so as to cover the element circuit surface of the semiconductor element 2. A metal thin film wiring layer (hereinafter also referred to as a "wiring layer") 7 constituting a metal wiring made of a conductive metal such as copper is formed on the insulating material layer 6, and a part thereof is led out to a peripheral region of the semiconductor element 2. Via parts 8 are provided on the electrode surface of the semiconductor element 2, and the wiring layer 7 and the electrodes of the semiconductor element 2 are thereby electrically connected. A plurality of external electrodes 9 such solder balls are formed at predetermined positions on the wiring layer 7. Metal vias 10 for electrically connecting the wiring layer 7 and the internal electrodes 5a, which are electrically connected to the through vias 4, are provided in the insulating material layer 6. A wiring protective film 11 is formed on the insulating material layer 6, and on the wiring layer 7 excluding the part that is bonded with the external electrodes 9. The wiring protective film 11 may be formed of a material that is the same as, or a material that is different from, the insulating material of the insulating material layer.

With the foregoing semiconductor device 20, the electrodes on the semiconductor element 2 are electrically connected to the metal vias 10 via the metal thin film wiring layer 7, and the metal vias 10 are electrically connected to the internal electrodes 5a on the organic substrate 1 and the external electrodes 9. Since the semiconductor device 20 is structured as described above, the terminals (electrodes) of the semiconductor element 2 becomes electrically connected to the external electrodes (5b, 9) on both the front and back faces of the semiconductor device, and packages of the same structure can be stacked and mounted.

The method of manufacturing such semiconductor device 20 of Embodiment 1 is explained below.

With the manufacturing method explained below, the organic substrate 1 is caused to be considerably larger than the size of the semiconductor element 2 of the present invention, a plurality of semiconductor elements 2 are respectively mounted on the organic substrate 1 at intervals, a plurality of semiconductor devices are simultaneously manufactured via predetermined treatment processes, and the obtained plurality of semiconductor devices are ultimately divided into individual semiconductor devices so as to obtain a plurality of semiconductor devices.

Accordingly, by simultaneously manufacturing a plurality of semiconductor devices, it is possible to considerably inhibit the manufacture costs.

Moreover, while this Embodiment explained a semiconductor device having one semiconductor element on the organic substrate, a case of providing a plurality of semiconductor elements on the organic substrate is also an embodiment of the present invention.

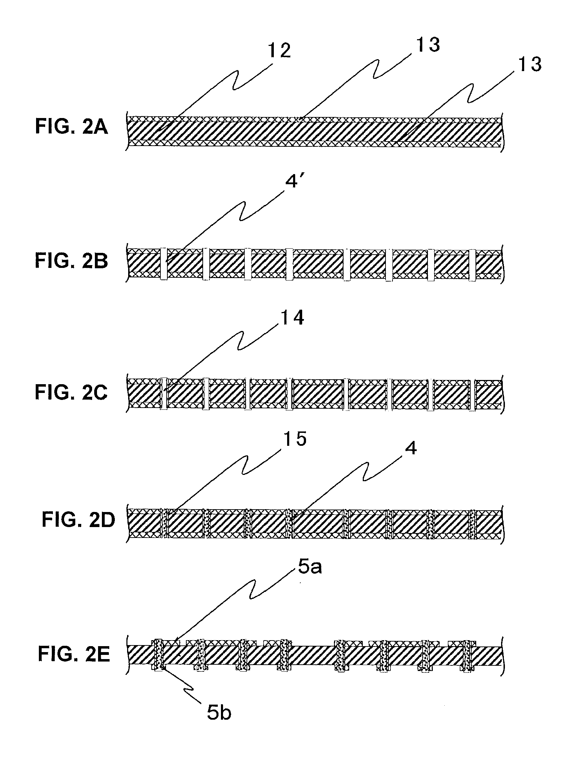

The manufacture process of the semiconductor device is now explained with reference to Figs. 2 to 4.

Fig. 2A is a diagram showing the organic substrate 1 before forming the through vias. As the organic substrate 1, used may be a substrate 12 in which a glass cloth is used as the base material, and thermosetting resin such as epoxy resin is impregnated therein and hardened. A copper foil 13 is attached and fixed to the front and back faces of the substrate 12.

Fig. 2B is a diagram showing a state where through-holes 4' , which are used for forming the through vias, are formed in the organic substrate 1. The through-holes 4' are formed by using a micro-hole drill. In the drawing, while the copper foil 13 and the substrate 12 are collectively processed with a drill, it is also possible to form the through-holes with a laser by eliminating the copper foil 13 immediately above the through-holes with a chemical or the like in advance.

Fig. 2C is a diagram showing a state where through vias are formed by using electrolytic plating or the like to form a plating layer 14 on the side walls of the through-holes 4'. Here, the plating layer 14 on the side walls is in a state of being electrically conductive with the copper foil 13.

Fig. 2D is a diagram showing a state where a conductive material 15 is filled in the through vias 4. The conductive material 15 may be formed by plating or formed by filling conductive paste after forming the plating layer 14. When the plating layer 14 has sufficient thickness and good electrical connection is obtained with only the plating layer, the process of filling of the conductive material can be omitted. Moreover, a hole-filling material may be filled in substitute for filling a conductive material in order to improve the rigidity of the through vias and facilitate the formation of the metal electrodes.

Fig. 2E is a diagram showing a state where internal electrodes 5a for connecting to the wiring layer and the external electrodes 5b to become the connecting part of the semiconductor device are formed by processing the copper foil 13 into an arbitrary shape. The processing of the copper foil can be performed via etching treatment or the like using a chemical.

Moreover, after forming the through vias 4 in the organic substrate 1, it is also possible to form a wiring protective film such as a solder resist on both faces or one face of the substrate in order to protect the wire. When a wiring protective film is provided, openings for connecting to the external electrodes are provided to the through vias 4 and the wiring part.

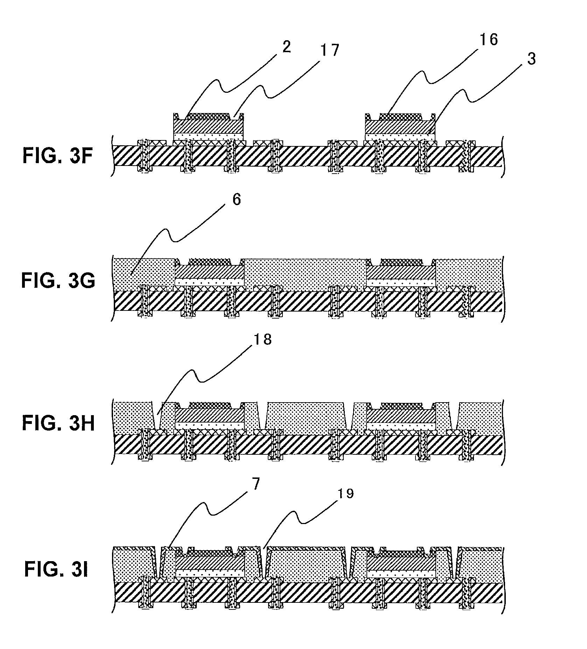

Fig. 3F is a diagram showing a state where semiconductor elements 2, determined as being non-defective in electrical property testing, are fixed on the organic substrate obtained with the foregoing processes, via an adhesive 3, with the element circuit surfaces thereof facing up. A photosensitive resin film 16 is applied to the surface of the semiconductor elements 2, and the electrodes (metal electrode terminals for external connection) of the semiconductor elements 2 are exposed due to the openings 17 formed in the photosensitive resin film 16. There are cases where, in a state where the photosensitive resin film 16 is not applied, the semiconductor elements 2 are fixed to the substrate. Here, since the substrate is considerably larger than the semiconductor size, numerous semiconductor elements 2 can be mounted.

Fig. 3G is a diagram showing a state where insulating resin was supplied to the periphery of the semiconductor elements 2 fixed on the substrate and an insulating resin layer 6 was thereby formed. Thermosetting resin is used as the insulating resin, and such insulating resin is supplied so as to avoid, as much as possible, any unevenness between the semiconductor elements 2 and the photosensitive resin film 16. The insulating resin can be supplied via an application method using a spin coater, or a printing method using a squeegee.

Photosensitive resin can also be used as the insulating resin. Moreover, in cases where a photosensitive resin film 16 is not supplied to the circuit forming faces of the semiconductor elements 2 in advance, it is also possible to supply photosensitive resin as the insulating resin to the periphery of the semiconductor elements 2 and to the circuit forming faces.

Here, the electrode parts of the circuit forming faces of the semiconductor elements 2 expose the electrode surfaces via openings that are opened in a separate process of exposure and development.

Here, it is also possible to simultaneously form openings (refer to 18 of Fig. 3H) for metal vias of the resin part.

Fig. 3H is a diagram showing a state where openings 18 for forming metal vias are formed in the insulating material layer 6. The openings 18 are processed with a laser or the like, and the openings 18 penetrate through to the internal electrodes 5a of the organic substrate. The openings 18 are sometimes processed and formed with a micro-hole drill, and is sometimes opened via exposure and development when the insulating material layer 6 is made of photosensitive resin.

Fig. 3I is a diagram showing a state where a metal thin film wiring layer 7 is formed on the insulating material layer 6 with openings 18 formed therein, and on the surface layer on the semiconductor elements 2. An underlayer (seed layer) is formed on the entire upper face of the insulating material layer 6 by a vapor deposition method (sputtering), electroless plating or the like, and electrolytic plating is thereafter performed. Here, as shown in the drawing, a conductive metal layer is also formed on the side walls of the openings 18 of the insulating material layer 6 by plating, and metal vias 19 are thereby formed. Subsequently, the conductive metal layer formed on the entire surface is patterned by photolithography and the metal thin film wiring layer 7 is formed. The patterning by photolithography can be performed by forming a photosensitive resist layer on the conductive metal layer, performing exposure and development using a mask of a predetermined pattern, and thereafter etching the predetermined portions of the conductive metal layer. By this kind of patterning by photolithography and electrolytic plating, it is possible to collectively form the metal vias 19 electrically connected to the electrodes of the semiconductor elements 2, the wiring layer 7, and the predetermined parts of the metal thin film wiring layer 7 where the external electrodes 9 made of solder ball or the like are to be formed in a subsequent process. Moreover, after forming the metal thin film wiring layer 7, the foregoing underlayer (seed layer) is removed by etching.

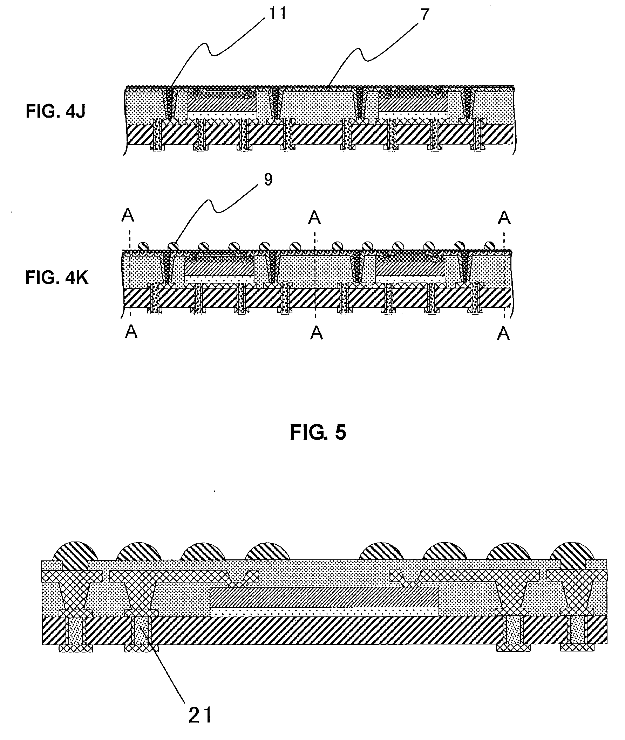

Fig. 4J is a diagram showing a state where a wiring protective film 11 such as a solder resist is formed on the metal thin film wiring layer 7.

The solder resist is supplied with a roll coater when the solder resist is in a liquid form, and supplied by lamination or bonding press when the solder resist is of a film shape. After forming the wiring protective film 11, openings for providing external metal electrodes to the wiring protective film are formed.

Fig. 4K is a diagram showing a state where an external metal electrodes 9 made of a conductive material are formed on the external metal electrode terminal parts of the metal thin film wiring layer 7. As the conductive material, conductive materials such as a solder ball, conductive paste, solder paste and the like are used.

After forming the external electrodes 9, by dividing the product obtained as mentioned above into individual pieces along the A-A cutting line, the semiconductor devices of Embodiment 1 of the present invention can be obtained.

### Embodiment 2

Fig. 5 is a cross-sectional view showing Embodiment 2 of the present invention.

Embodiment 2 has a structure where, in Embodiment 1, a metal conductor is formed only on the wall surface of the through vias, and a hole-filling material 21 such as resin is filled in the remaining hollow portion.

As a result of filling the hole-filling material 21, the rigidity of the through vias can be increased, and the formation of metal electrodes (conductive films) on the upper and lower faces of the through vias are facilitated.

### Embodiment 3

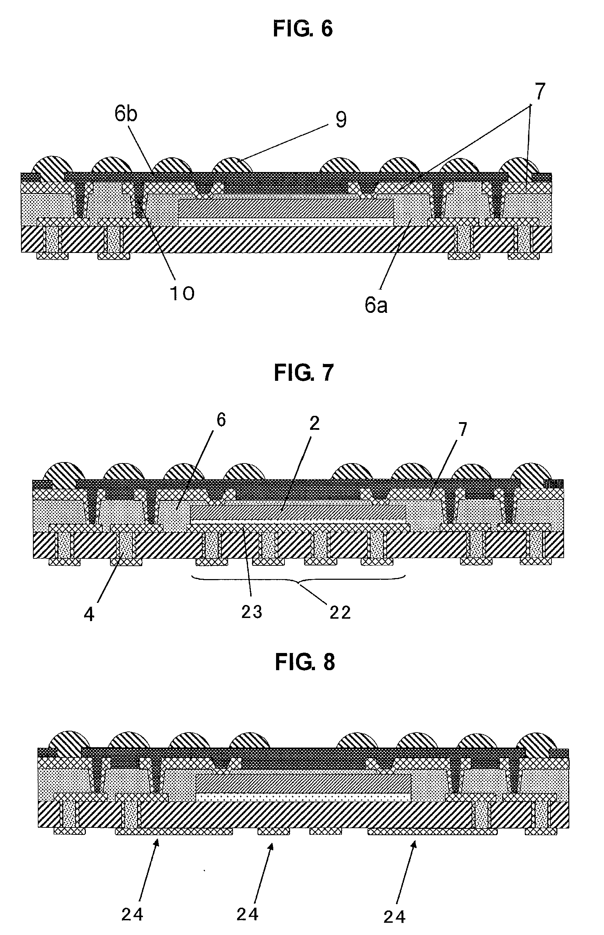

Fig. 6 is a cross-sectional view showing Embodiment 3 of the present invention.

Embodiment 3 uses different types of resin on the lower side and upper side of the wiring layer as the insulating material layer 6 around the semiconductor element in Embodiment 1. For example, thermosetting resin or photosensitive resin is used as the resin 6a, and an insulating resin material such as a solder resist that can insulate between the external electrodes is used as the resin 6b. The layer made of the resin 6b constitutes the wiring protective layer 11.

As a result of adopting the foregoing configuration, the enhancing effect of the sealing reliability for the semiconductor elements by using thermosetting resin as the resin 6a, the enhancing effect of the patterning properties by using photosensitive resin as the resin 6a, and the short-circuit prevention effect between the external electrodes by using solder resist as the resin 6b can be expected, respectively.

Moreover, in the illustrated example, the through vias of the organic substrate are filled with a hole-filling material as in Embodiment 2.

### Embodiment 4

Fig. 7 is a cross-sectional view showing Embodiment 4 of the present invention.

Embodiment 4 improves the heat release properties of the heat generated by the semiconductor element 2 by leaving the copper foil on the surface portion of the organic substrate 1 facing the semiconductor element 2 in Embodiment 3 to form Cu electrode pads 23, disposing dummy through vias 22, which are not electrically connected to the metal thin film wiring layer 7 in the insulating material layer 6, in the organic substrate 1 positioned below the Cu electrode pads 23, and causing the through vias to be thermal vias.

As a result of using the semiconductor device having the foregoing structure in a stacked module, heat will flow efficiently in the vertical direction, and heat release is facilitated.

### Embodiment 5

Fig. 8 is a cross-sectional view showing Embodiment 5 of the present invention.

Embodiment 5 connects the lower face of the organic substrate in Embodiment 3 to wirings 24. As a result of adopting the foregoing structure, rewiring to different pad positions from through vias in the organic substrate is enabled. Moreover, as a result of increasing the patterning area, the heat release properties can be improved based on the uniformity of the in-plane temperature distribution.

### Embodiment 6

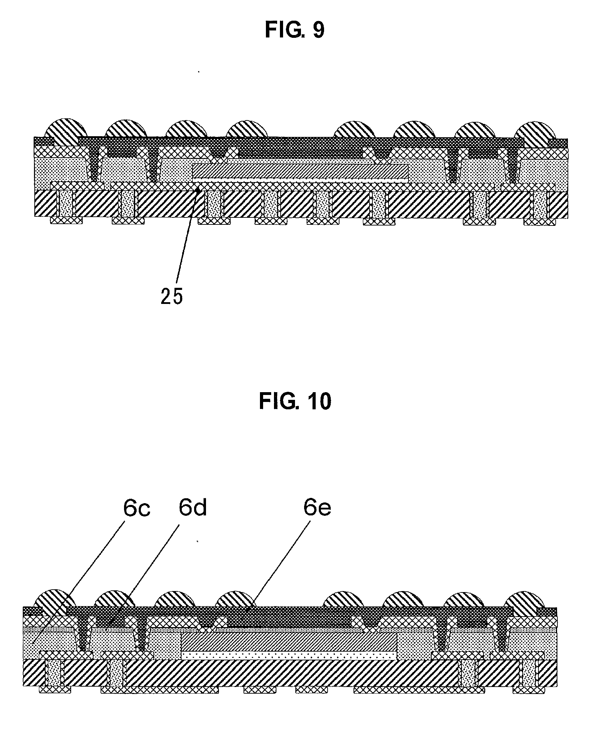

Fig. 9 is a cross-sectional view showing Embodiment 6 of the present invention.

Embodiment 6 is a modified example of Embodiment 4, and the area of the copper foil on the surface portion of the organic substrate 1 facing the semiconductor element 2 is left as a large area, and used as a ground layer 25.

This configuration enables the improvement in heat release properties, and improvement of electrical properties based on reinforcement of the ground layer.

### Embodiment 7

Fig. 10 is a cross-sectional view showing Embodiment 7 of the present invention.

Embodiment 7 is a configuration where, as the insulating material layer 6 around the semiconductor element in Embodiment 5, a thermosetting resin layer 6c is used as the lowermost layer, a photosensitive resin layer 6d is used as the layer thereabove, and a solder resist layer 6e is used as the uppermost layer. As a result of adopting the foregoing structure, the enhancing effect of the sealing reliability for the semiconductor elements by the thermosetting resin layer 6c, the enhancing effect of the patterning properties by the photosensitive resin layer 6d, and the short-circuit prevention effect between the external electrodes by solder resist layer 6e can be expected, respectively.

### Embodiment 8

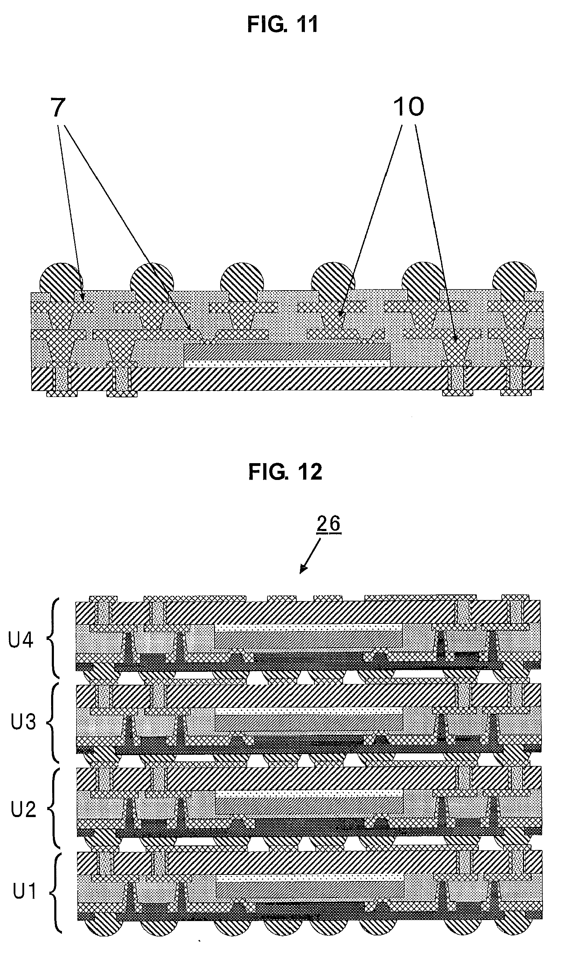

Fig. 11 is a cross-sectional view showing Embodiment 8 of the present invention.

Embodiment 8 provides metal thin film wiring layers 7 and metal vias 10 to be connected thereto in plural layers (two layers each in the illustrated example).

Provision of a plurality of metal thin film wiring layers 7 and metal vias 10 to be connected thereto increases the freedom of wiring in electrically connecting the semiconductor element and the external metal electrodes or the metal vias, and thus the freedom of the mountable semiconductor element size can be increased, or the freedom of the number of mountable electrode terminals of the semiconductor element surface can be increased, as compared with semiconductor devices of the same external size.

### Embodiment 9

Fig. 12 is a cross-sectional view showing Embodiment 9 of the present invention.

Embodiment 9 is a semiconductor stacked module 26 obtained by stacking units (U1 to U4) of the semiconductor device in a direction that is vertical to the main plane of the semiconductor device by connecting the external electrodes formed on the metal thin film wiring layer of the semiconductor device and the external electrodes exposed on the organic substrate of another semiconductor device.

'As a result of using the semiconductor device of the present invention as a stacked module unit, it is possible to realize a stacked module of an arbitrary number of stacks without having to provide through electrodes to the semiconductor elements as in a TSV structure, and even when the size of the individual semiconductor elements is different.

### Embodiment 10

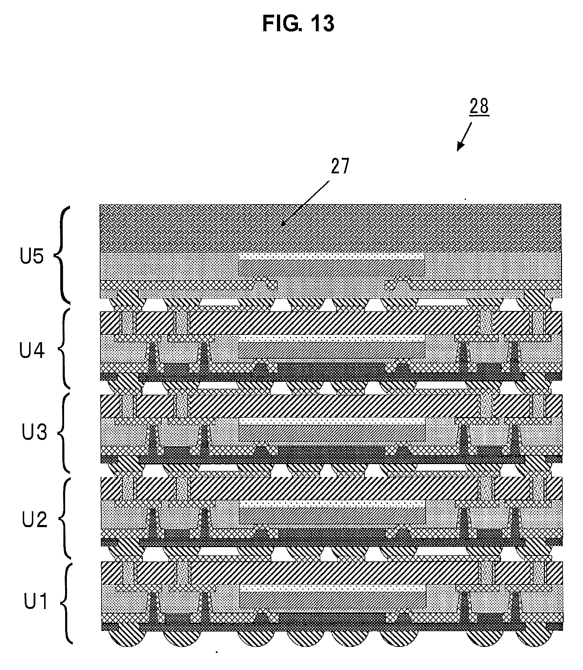

Fig. 13 is a cross-sectional view showing Embodiment 10 of the present invention.

Embodiment 10 is a semiconductor stacked module 28 obtained by disposing the semiconductor device U5 having the structure shown in Fig. 14 on the uppermost layer of the semiconductor stacked module 26 of Embodiment 9 shown in Fig. 12.

With the semiconductor device U5 shown in Fig. 14, a highly heat-conductive metal plate 27 is used as the flat plate 31, and it is thereby possible to realize a stacked module with high heat-release performance in which high power consumption semiconductor elements can be mounted on the uppermost layer.

## Claims

1. A semiconductor device, comprising:
an organic substrate;
through vias which penetrate the organic substrate in its thickness direction;
external electrodes and internal electrodes provided to the front and back faces of the organic substrate and electrically connected to the through vias;
a semiconductor element mounted on one main surface of the organic substrate via a bonding layer, with an element circuit surface thereof facing upward;
an insulating material layer for sealing the semiconductor element and a periphery thereof;
a metal thin film wiring layer provided in the insulating material layer, with a part of this metal thin film wiring layer being exposed on an external surface;
metal vias provided in the insulating material layer and electrically connected to the metal thin film wiring layer; and
external electrodes formed on the metal thin film wiring layer,
wherein the metal thin film wiring layer is structured such that the electrodes disposed on the element circuit surface of the semiconductor element, the internal electrodes, the metal vias, and the external electrodes formed on the metal thin film wiring layer are electrically connected.

2. The semiconductor device according to claim 1, wherein the insulating material layer is formed of a plurality of insulating material layers made of respectively different insulating materials.

3. The semiconductor device according to claim 1 or 2, wherein the metal thin film wiring layer and the metal vias connected thereto are provided in the form of a plurality of layers.

4. The semiconductor device according to any one of claims 1 to 3, wherein through vias, which are not electrically connected to the metal thin film wiring layer in the insulating material layer, is disposed in a region of the organic substrate facing the semiconductor element.

5. The semiconductor device according to any one of claims 1 to 4, wherein a plurality of semiconductor elements are provided on the organic substrate.

6. A module structure in which a plurality of the semiconductor devices according to any one of claims 1 to 5 are stacked in a direction which is vertical to a main plane of the semiconductor device by connecting the external electrodes formed on the metal thin film wiring layer of one of the semiconductor devices and the external electrodes exposed on the organic substrate of the other semiconductor device.

7. The module structure according to claim 6, wherein the semiconductor device is the semiconductor device according to claim 4.

8. A method of manufacturing a semiconductor device, comprising the steps of:
forming in an organic substrate through vias which penetrate the organic substrate in a thickness direction;
forming external electrodes and internal electrodes provided to the front and back faces of the organic substrate and electrically connected to the through vias;
positioning and disposing a plurality of semiconductor elements on one main surface of the organic substrate, with element circuit surfaces thereof facing upward, and then fixing faces, which are opposite to the element circuit surfaces of these semiconductor elements, onto the organic substrate;
forming an insulating material layer on the semiconductor elements and a periphery thereof;
forming openings in the insulating material layer;
forming on the insulating material layer a metal thin film wiring layer, a part of which extends to a peripheral region of the semiconductor element, and forming metal vias as conductive parts, which are connected to electrodes disposed on the element circuit surfaces of the semiconductor elements, in the openings in the insulating material layer;
forming external electrodes on the metal thin film wiring layer; and
separating the semiconductor devices including one or more semiconductor chips by cutting the organic substrate and the insulating material layer at predetermined positions.

9. A method of manufacturing a semiconductor stacked module, wherein a plurality of the semiconductor devices according to any one of claims 1 to 5 stacked in a direction which is vertical to a main plane of the semiconductor device in such a manner that the external electrodes formed on the metal thin film wiring layer of one of the semiconductor devices are connected to the external electrodes exposed on the organic substrate of another semiconductor device.
